# EUROPÄISCHE PATENTANMELDUNG

(11) **EP 2 670 159 A2**
(43) Veröffentlichungstag der Anmeldung: **04.12.2013**
(21) Anmeldenummer: 13169673.4
(22) Anmeldetag: 29.05.2013
(51) Int. Cl.: H04Q 1/02, H05K 7/18

(54) **Dach-/Bodenelement und Verteilerschrank**

(30) Priorität: 29.05.2012 DE 102012208981; 29.05.2012 DE 202012101958 U
(71) Anmelder: VV-Hammer GmbH, 73489 Jagstzell (DE)
(72) Erfinder: Hammer, Ralf, 73489 Jagstzell (DE)
(74) Vertreter: Raunecker, Klaus Peter

(57) **Zusammenfassung**

Die Erfindung schließt ein Dach-/Bodenelement für einen Verteilerschrank ein, welches ein Abschlussblech, Seitenflächen und einen Innenflansch aufweist, wobei das Dach-/Bodenelement einstückig ausgebildet ist.

Ein weiterer Aspekt der Erfindung betrifft einen Verteilerschrank mit einem erfindungsgemäßen Dachelement und einem Bodenelement.

## Beschreibung

Die Erfindung betrifft ein Dach-/Bodenelement gemäß dem Oberbegriff des Anspruchs 1 sowie einen Verteilerschrank gemäß dem Oberbegriff des Anspruchs 14.

Verteilersysteme von Lichtwellenleitern (LWL) bestehen unter anderem meist aus Spleißboxen, Kabelführungskanälen und Kabelabfangschienen, die in einem Verteilerschrank angeordnet sind. Bei den bekannten Lichtwellenleiterverteilern werden als Spleißboxen bezeichnete Aufnahmekammern zur Trennung der Teile in eingangs- und ausgangsseitige Teilbereiche eingebaut.

Aus der deutschen Druckschrift DE 20 2011 004 313 U1 sind bereits im Fachgebiet der Telekommunikationstechnologie Gestelle zusammen mit einem Managementsystem für die Lichtleitertechnik bekannt, das eine hohe Verfügbarkeitsrate von Lichtleiterkabeln für Kommunikationszwecke in einem Verteilungsnetz, einem Zugangsnetz, einem Weitverkehrsnetz und dergleichen ermöglicht. Bei den Gestellen handelt es sich üblicherweise um ein Metallgestell zur Unterbringung aller Systemkomponenten für den Lichtleiterkabelabschluss und das Lichtleiterkabelmanagement, zur Aufnahme und Führung von Anschlussfasern oder Überbrückungen. Das Gestell umfasst normalerweise insbesondere einen Basisrahmen und bei Bedarf Seitenkanäle zur Aufnahme von Spleißrosten, Umschalt- und Mischrosten.

Auch aus der Praxis bekannt sind bei passiven Glasfaser Management Systemen Verteilerschränke, in denen separate Spleiß- und Patchbaugruppen mit weiteren Elementen zur Kabelführung eingebaut sind. Das äußere Gestell eines Verteilerschranks ist aus einer Vielzahl von Einzelteilen mittels Verschraubungen zusammengesetzt. Insbesondere die Dachelemente und Bodenelemente bestehen unter anderem aus einer größeren Anzahl an Profilen und stabilisierend gefalzten Elementen.

Aufgabe der Erfindung ist, einen aus mehreren Elementen zusammengesetzten Verteilerschrank weiterzubilden und hierzu Systemkomponenten zu vereinfachen.

Erfindungsgemäß wird diese Aufgabe bezüglich eines Dach-/Bodenelements mit den in Anspruch 1 genannten Merkmalen und bezüglich eines Verteilerschranks mit den in Anspruch 14 genannten Merkmalen gelöst. Die weiteren rückbezogenen Ansprüche betreffen vorteilhafte Aus- und Weiterbildungen der Erfindung.

Die Erfindung schließt ein Dach-/Bodenelement für einen Verteilerschrank ein, welches ein Abschlussblech, Seitenflächen und einen Innenflansch aufweist, wobei das Dach-/Bodenelement einstückig ausgebildet ist.

Die Erfindung geht dabei von der Überlegung aus, dass das Dach-/Bodenelement, auch als Dach-/Bodenrahmen bezeichnet, als identisches Element variabel sowohl als Boden wie auch als Dach, also die Oberseite, eines Verteilerschrankes verwendet werden kann. Derartige Dach-/Bodenelemente werden beispielsweise in Lichtwellenleiterverteilerschränken eingesetzt. Das Dachelement kann im Verteilerschrank dann spiegelsymmetrisch oder punktsymmetrisch zum Bodenelement montiert werden. Bei punktsymmetrischem Aufbau wird kann das Bodenelement gegenüber der Spiegelsymmetrie nochmals um 180° um eine zum Abschlussblech senkrecht stehende Achse gedreht werden, so dass die stirnseitige Vorderseite eines Bodenelements in der Verwendung als Dachelement zu dessen Rückseite wird. Das Dach-/Bodenelement ist aus einem Stück geformt, insbesondere gebogen und gekantet, ohne zwingend eine Schweißverbindung aufweisen zu müssen. Im Dach-/Bodenelement können im Abschlussblech, den Seitenflächen und dem Innenflansch an geeigneter Stelle einzelne Löcher oder auch regelmäßige Lochmuster angeordnet sein, an denen Befestigungseinrichtungen zur Halterung weiterer Systemkomponenten und Zubehörteilen montiert werden können. Es können auch an geeigneter Stelle größere Rundlöcher vorhanden sein, durch die beispielsweise Stromkabel hindurchgeführt werden.

Im Verteilerschrank werden von unten bzw. von oben über Durchführungen Kabel eingeführt, welche beispielsweise auf im Verteilerraum angeordnete Spleißboxen geführt werden. Die Kabel werden in den Spleißboxen üblicherweise entweder durch eine feste Spleißverbindung oder auch durch eine lose Steckverbindung untereinander verbunden. Um die Kabelstränge knickfrei zu verlegen, werden diese beispielsweise über tonnenförmige oder U-förmige Umlenkelemente oder anderweitige Elemente zur Kabelführung geführt. In dem über Türen gut zugänglichen Verteilerraum kann auch ein Doppelboden oder eine Bodenwanne so ausgeführt sein, dass die Kabel sicher verlegt werden können und diese entsprechend geschützt sind. Die Faserbündel werden ebenso in Wandkanälen in den Seitenteilen geführt und von dort aus, beispielsweise auf die Spleißboxen, weiterverteilt. Bei der gesamten Auslegung steht ein einfaches Verlegen der Kabel im Vordergrund, bei dem insbesondere ein Durchfädeln von Glasfaserkabeln durch enge Öffnungen vermieden wird.

Die Stabilität eines Dach-/Bodenelements kann unter anderem auf einem zumindest zweifachen Falzen des Stanzbleches zur Ausbildung der Seitenflächen und des Innenflansches beruhen. Durch das mehrfache Biegen und die Einstückigkeit wird eine verwindungssteife und selbsttragende Konstruktion bewirkt.

Ein Vorteil der Erfindung ist, dass bei einem universell einsetzbaren Verteilerschrankelement nicht überlegt werden muss, welches als Dachelement und welches als Bodenelement zu verwenden ist. Gleiche Ausführungen vereinfachen wesentlich den konstruktiven Aufwand in der Verwendung für das Gesamtsystem. Ein derartiges Multielement ist daher symmetrisch aufgebaut, um es in mehreren Einbauvarianten in einem Verteilerschrank einbinden zu können.

In bevorzugter Ausgestaltung können randseitig Aufnahmeelemente zum wahlweisen Befestigen von Transportösen oder von Stellfüßen angeordnet sein. Durch eine flexible Verwendung als Dachelement oder Bodenelement werden wahlweise Transportösen auf der Oberseite eines Verteilerschranks oder Stellfüße für die Unterseite montiert. Die Montage erfolgt an Universalhalterungen als Aufnahmeelemente, die als Zubehörteile zunächst selbst am Rahmen angebracht werden müssen.

Vorteilhafterweise kann das jeweilige Aufnahmeelement mehrere in Flucht hintereinander angeordnete Gewindeelemente mit unterschiedlichem Gewindeinnendurchmesser beinhalten, wobei das dem Abschlussblech nächstliegende Gewindeelement den größten Gewindeinnendurchmesser, das dem Abschlussblech fernliegenste Gewindeelement den kleinsten Gewindeinnendurchmesser aufweist. Unterschiedliche Gewindeelemente im Aufnahmeelement tragen den unterschiedlichen Anforderungen im variablen Einsatz als Dachelement oder Bodenelement Rechnung. Die Gewindeelemente können beispielsweise hintereinander angeordnete Muttern sein oder auch aus U-Profilen mit eingeschnittenem Gewinde aufgebaut sein. In den Flanschen des U-Profils, die parallel zum Abschlussblech angeordnet werden, sind dann beispielsweise die unterschiedlichen Gewindedurchmesser M8 und M16 oder M18 eingeschnitten. Mit anderen Worten: Eine Montage von Halteösen oder Standfüßen zeichnet sich dadurch aus, dass das Aufnahmeelement auf der ins Innere eines Verteilerschrankes gerichteten Seite ein M8-Gewinde hat und auf der nach außen gerichteten Seite ein M16-Gewinde. So kann mit einer 8er-Schraube eines Stellfußes das 16er-Gewinde durchfahren und im dahinter liegenden M8-Gewinde verschraubt werden. Die Aufnahmeelemente sind beispielsweise als Universalhalterungen ausgeführt, die mit Schrauben in den Ecken eines Dach-/Bodenelements gehalten werden.

Ebenso kommt als Aufnahmeelement Vollmaterial mit eingeschnittenen Gewindegängen in Betracht. Die Aufnahmeelemente aus Profilen oder Vollmaterial haben von sich aus bereits die benötigte Stabilität, um den an einer Transportöse oder an einem Fuß angreifenden Kräfte standzuhalten. Im Regelfall sind die Aufnahmeelemente in den Ecken eines Dach- oder Bodenelements angeordnet. So werden beispielsweise die Transportösen in M16-Gewinde eingeschraubt, die Stellfüße in ein M8-Gewinde. In diesem Fall liegt vom Abschlussblech aus gesehen das größere M16-Gewinde hinter dem kleineren M8-Gewinde.

Es können aber auch mehr als zwei Gewindeelemente in Flucht mit abnehmenden Gewindedurchmessern hintereinander angeordnet werden. Die Auswahl der Gewindedurchmesser und deren Reihenfolge ergeben sich daraus, dass die jeweilige Verschraubung durch alle größeren Gewinde bis zum passenden Gewindedurchmesser hindurchgesteckt und dann verschraubt werden kann. Dies macht die Konzeption von Deckel und Boden besonders flexibel.

Alternativ kann vorteilhafterweise das jeweilige Aufnahmeelement als Winkelelement an den Seitenflächen fixiert sein und mit zumindest einem Gewindeelement als Haltevorrichtung ausgestaltet sein. Bevorzugt ist dabei in jeder Ecke eines Dach-/Bodenelements ein Winkelelement angeordnet, welches zwei Funktionen übernehmen kann. Als Bodenelement kann es einen Gestellfuß halten, in der Verwendung als Dachelement dient es beispielsweise zur Halterung einer Transportöse.

Üblicherweise handelt es sich bei den Winkelelementen um dreieckige Flachbleche mit einer Haltevorrichtung, welche auf der Innenseite der Ecken eines Dach-/Bodenelements eingesetzt und dort beispielsweise durch Schweißnähte fest verbunden sind. Hierbei kann auch das Dach-/Bodenelement als ganzes verschweißt oder auch zumindest teilweise verschraubt sein. Aus Kostengründen kann ein komplettes Verschweißen jedoch besonders günstig sein. Mit anderen Worten: Bei dem Winkelelement handelt es sich um ein sogenanntes Knotenblech, das in den Ecken eines Dach-/Bodenelements eingeschweißt ist.

Derartige Knotenblech bestehen bevorzugt aus Stahlblech und weisen eine Dicke von einigen Millimetern auf, bevorzugt um 4 mm.

Alternativ können auch Biegevarianten mit Gehrungen vorgesehen werden, die beispielsweise auf der Innenseite im Dach-/Bodenelement verschraubt oder ebenfalls verschweißt sind.

Als Gewindeelement kann auf eine Öffnung im Knotenblech eine Mutter deckungsgleich aufgeschweißt oder diese in die Öffnung eingeschweißt werden. Bevorzugt handelt es sich um Schweißmuttern, Setz-, Einpress- oder Nietmuttern mit Verdrehschutz, die jeweils auch größere Kräfte aufnehmen können. Beispielsweise erweist sich eine einheitliche Gewindegröße M10 als Sechskantmutter bereits als geeignet, die an den Stellfüßen oder Trageösen auftretenden Kräfte aufzunehmen. Gegebenenfalls können jedoch auch andere Gewinde oder Materialien zum Einsatz kommen. Dabei können auch bei eingeschweißten Gewindeelementen an zwei Seiten, also auf der Ober- und Unterseite eines Knotenbleches, Schweißnähte angebracht werden, um sowohl auf Zug wie auch auf Druck belastbare Verbindungen zu schaffen.

Bevorzugt kann das Winkelelement mit Anschlusslaschen zur Verbindung in Ausnehmungen in den Seitenflächen ausgeführt sein. Bei den Anschlusslaschen handelt es sich um Auskragungen entlang der Kanten der Winkelelemente, um diese in entsprechenden Ausnehmungen der Seitenflächen eines Dach-/Bodenelements einzustecken und zu verschweißen. Es handelt sich folglich um randseitige Fortsätze eines Knotenblechs, die in die Ausnehmungen der Seitenflächen eingreifen. Hierdurch wird eine besonders stabile Verbindung geschaffen. Derartige Verbindungen sind darauf ausgelegt und dazu geeignet, mehrere hundert Kilo Traglast aufzunehmen.

In bevorzugter Ausgestaltung kann der innere Teil des Innenflansches zum Abschlussblech hin umgebogen sein. Hierdurch wird eine zusätzliche Steifigkeit der gesamten Struktur eines Dach-/Bodenelements erzielt. Auch Umkantungen an anderer Stelle können dazu dienen, die Steifigkeit der gesamten Konstruktion zu verbessern. Bei Kantungen, in deren Nähe Kabel verlegt werden, wird darauf geachtet, dass dort keine Ecken, scharfe Kanten oder ähnliches vorhanden sind, die ein Kabel beschädigen könnten oder den Bauraum beeinträchtigen. Eine komfortable Kabelführung ist ein wichtiges Kennzeichen des gesamten Verteilerschrankes.

In bevorzugter Ausgestaltung der Erfindung kann im Inneren zusätzlich ein sich über den mittleren Bereich erstreckender Kanal angeordnet sein. Der Kanal dient zur Kabelführung und auch als Versteifungsblech im Inneren des Dach-/Bodenelements. Dieser ist einerseits auf der Innenseite des Abschlussblechs und andererseits mit dem Innenflansch in zueinander passenden Lochmustern verschraubt, genietet oder anderweitig gefügt. Zum Fügen am Innenflansch ist die Seitenkante des Kanals etwas verbreitert. Die Fixierung des Kanals am Abschlussblech und am Innenflansch verleiht dem Dach-/Bodenelement eine besondere Steifigkeit und Torsionsfestigkeit.

In bevorzugter Ausgestaltung der Erfindung können Positionierschlitze oder Positioniernasen am Innenflansch angeordnet sein. Mit Positionierschlitzen oder Positioniernasen können die Seitenteile oder ggf. die Rückwand eines Verteilerschrankes, welche ebenfalls passende komplementäre Positioniereinrichtungen aufweisen, genau positioniert werden, bevor die Einzelteile miteinander verschraubt oder anderweitig verbunden werden. Beispielsweise werden auf dem Bodenelement die Seitenteile eingesteckt und fixiert, bevor das Dachelement auf die Seitenteile angebracht und ebenfalls befestigt wird.

Vorteilhafterweise können im Abschlussblech erste Ausnehmungen zur Durchführung von Kabeln eingebracht sein. Die Ausnehmungen im Abschlussblech dienen bei einem Verteilerschrank als Zugang der von außen herangeführten Kabel. Diese Durchführungen für eine Vielzahl von Kabeln sind im Regelfall großflächig und rechteckig oder quadratisch ausgeführt. Um Schmutzeintrag zur verhindern kann nach der Montage die Restöffnung mit Abdeckplatten verschlossen werden, die entweder verschraubt oder mit Federclips gehalten werden. Alternativ können spezielle Abdeckplatten angebracht werden, welche selbst Löcher bzw. weitere Ausnehmungen aufweisen und die einheitlich ausgeführte Öffnung der ursprünglichen Ausnehmung im Dach-/Bodenelement in geeigneter Weise verkleinern. So werden, je nach Bedarf, bereits vor der Verkabelung die benötigten Durchtrittsstellen in ihrer Größe variabel angepasst.

Vorteilhafterweise können im Abschlussblech weitere Ausnehmungen zur Anordnung weiterer Systemelemente eingebracht sein. Ausnehmungen zur Anordnung weiterer Systemelemente sind beispielsweise Verschraubungslöcher oder auch Ausstanzungen zum Einrasten und Fixieren von weiteren Systemkomponenten, wie beispielsweise tonnenartige Führungselemente zur Biegekontrolle und Halterungen für Kabel oder Rohre. Weitere Ausnehmungen können beispielsweise T-förmig ausgebildet sein und als Befestigungsstellen für Kabelbinder dienen.

Bevorzugt kann Stahlblech oder verzinktes Stahlblech verwendet sein. Hier kommen beispielsweise Stähle nach EN 10027 in Betracht. Verzinktes Stahlblech kann noch günstiger sein, da es durch einfaches Stanzen, Biegen und Kanten zu einem Dach-/Bodenelement ausgeformt werden kann. Beim Stanzen eines verzinkten Bleches wird die Zink-Oberflächenbeschichtung mit um die Stanzkanten gezogen und sorgt auch ohne weiteren Beschichtungsaufwand für einen ausreichenden Korrosionsschutz. Zudem kann eine Stanzkante auch mit einem Kantenschutz versehen werden.

Vorteilhafterweise kann die Oberfläche eines Dach-/Bodenelements pulverbeschichtet sein. Pulverbeschichtetes Stahlblech hat bereits einen ausreichenden Korrosionsschutz. Es handelt sich dabei um eine Konstruktion ohne jegliche Schweißverbindung.

Vorteilhafterweise kann ein Dach-/Bodenelement aus einem gebogenen und gefügten, zunächst ebenen Blechmaterial gebildet sein. Es handelt sich um ein geometrisch einfaches Biegeteil, aus dem ein Dach-/Bodenelement vorgeformt wird. Dieses kann anschließend an den daraus entstehenden gemeinsamen Fügekanten als ganzes verschweißt oder auch zumindest teilweise verschraubt oder durch Falzen stabilisiert werden. Aus Kostengründen ist ein komplettes Verschweißen jedoch besonders günstig. Das Ausgangsblech selbst kann durch Lasertrennen ausgeformt und geschnitten werden.

Ein weiterer Aspekt der Erfindung betrifft einen Verteilerschrank mit einem Dachelement und ein Bodenelement nach einem der Ansprüche 1 bis 13 und Seitenteilen sowie wahlweise weiteren Systemelementen. Ein vormontierter Verteilerschrank mit einem Bodenelement, einem Dachelement und zwei gleichartigen Seitenteilen und ggf. einer Rückwand kann entsprechend seiner Symmetrie noch beliebig ausgerichtet und sogar umgedreht werden. Folglich wird ein Verteilerschrank aus zwei Arten an Grundelementen, den Dach-/Bodenelementen und den Seitenteilen, aufgebaut. Dabei können sowohl die Dach-/Bodenelemente wie auch die Seitenteile identisch oder symmetrisch in der Art von Multielementen ausgebildet sein. An dieses Grundgerüst werden weitere Systemelemente und Zubehörteile, wie beispielsweise Kabelführungskanäle, Kabelplatte, Kabelführungstonnen oder Erdungseinrichtungen, angeordnet. Die Zweckbestimmung eines Dach-/Bodenelements ergibt sich erst nach der Montage der Transportösen oder der Stellfüße.

Weitere vorteilhafte Weiterbildungen und Ausgestaltungen der Erfindung ergeben sich aus den nachfolgend anhand der Zeichnungen prinzipmäßig beschriebenen Ausführungsbeispielen.

Es zeigt:
- Fig. 1: schematisch eine Schrägansicht eines Dach-/Bodenelements;
- Fig. 2: schematisch eine Schrägansicht eines Dach-/Bodenelements mit weiteren Systemkomponenten;

- Fig. 3: schematisch eine Detailansicht eines Aufnahmeelements als Systemkomponente;
- Fig. 4: schematisch eine Vorderansicht eines Dach-/Bodenelements gemäß Fig. 2;
- Fig. 5: schematisch eine Draufsicht auf ein Dach-/Bodenelements gemäß Fig. 2;
- Fig. 6: schematisch eine Seitenansicht eines Dach-/Bodenelements gemäß Fig. 2;
- Fig. 7: schematisch eine Schrägansicht eines Dach-/Bodenelements mit alternativem Aufnahmeelement;
- Fig. 8: schematisch eine Draufsicht auf ein Blech, zur Ausbildung eines Dach-/Bodenelements;
- Fig. 9: schematisch ein Verteilerschrank mit Dach-/Bodenelementen;
- Fig. 10: schematisch eine Vorderansicht eines Verteilerschranks;
- Fig. 11: schematisch eine Rückansicht eines Verteilerschranks;
- Fig. 12: schematisch eine Seitenansicht eines Verteilerschranks; und
- Fig. 13: schematisch eine Schrägansicht eines Verteilerschranks.

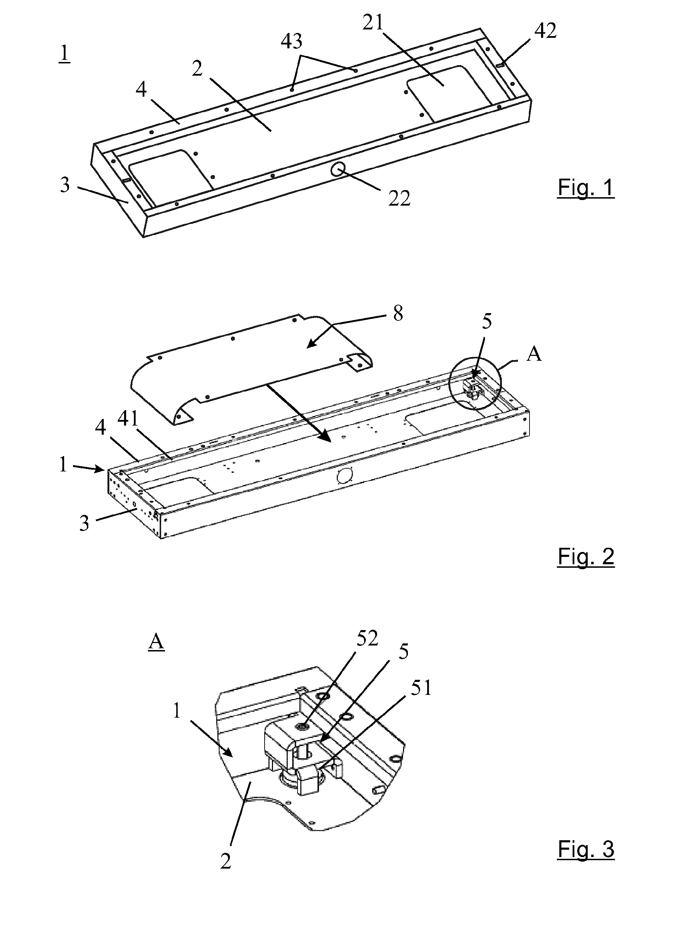

Fig. 1 zeigt schematisch eine Schrägansicht eines Dach-/Bodenelements 1. Das Dach-/Bodenelement 1 ist aus einem Stück geformt und variabel sowohl als Boden wie auch als Dach einsetzbar. Fügeverfahren, wie beispielsweise Schweißen, sind bei dieser Ausführungsform überflüssig. Im Wesentlichen besteht das Dach-/Bodenelement 1 aus einem Abschlussblech 2, Seitenflächen 3 und einem Innenflansch 4. Die Stabilität eines Dach-/Bodenelements 1 beruht unter anderem auf einem mehrfachen Falzen eines Stanzbleches zur Ausbildung der Seitenflächen und des Innenflansches. Durch das mehrfache Biegen und die Einstückigkeit wird eine besonders stabile Konstruktion erzielt. Erste Ausnehmungen 21 sind im Abschlussblech 2 eingebracht und dienen als Durchtrittsstellen für zu einem späteren Zeitpunkt in einen Verteilerschrank eingebrachte Kabel. Weitere Ausnehmungen 22 sind Durchtrittsöffnungen für weitere Systemkomponenten. Hier handelt es sich beispielsweise um Öffnungen für eine Steckdose. Diese Öffnung liegt im Regelfall an der zugänglichen Vorderseite des Schranks. Die Positionierschlitze 42 dienen als Montagehilfe beispielsweise für die Seitenteile oder ggf. die Rückwand eines Verteilerschrankes. Zum Verschrauben der einzelnen Systemkomponenten eines Verteilerschrankes dienen die Bohrungen 43.

Fig. 2 zeigt schematisch eine Schrägansicht eines Dach-/Bodenelements 1 mit einem Aufnahmeelement 5 und einem Kanal 8 als weitere Systemkomponente. Einerseits wird die Steifigkeit eines Dach-/Bodenelements 1 bereits dadurch verstärkt, indem der Innenflansch 4 nochmals im inneren Teil des Innenflansches 41 umgebogen ist. Zudem kann im Inneren zusätzlich ein sich über den mittleren Bereich erstreckender Kanal 8 angeordnet werden. Der Kanal 8 ist in der Figur 2 unmittelbar vor dem Einbringen dargestellt. Dieser dient zur Kabelführung und auch als Versteifungsblech im Inneren des Dach-/Bodenelements 1. Dazu wird der Kanal 8 einerseits auf der Innenseite des Abschlussblechs 2 und andererseits mit dem Innenflansch 4 verschraubt. Durch den verbreiterten mittleren Bereich des Kanals 8 kann dieser zum Fügen am Innenflansch aufgelegt werden. Die Fixierung des Kanals 8 am Abschlussblech 2 und am Innenflansch 4 verleiht dem Dach-/Bodenelement insbesondere Torsionsfestigkeit. Die Aufnahmeelemente 5 sind an den jeweiligen Ecken des Dach-/Bodenelements 1 angeordnet. Der Kanal 8 ist im gezeigten Beispiel nicht als klassischer Kanal ausgebildet, sondern eher in der Art einer Kabelabfangplatte zur Führung bzw. Ablage der Kabel.

Fig. 3 zeigt schematisch eine Detailansicht eines Aufnahmeelements 5 als Systemkomponente. Die Aufnahmeelemente 5 sind dafür vorgesehen, im Falle einer Verwendung als Dachelement, Transportösen zu haltern oder in der Verwendung als Bodenelement Standfüße aufzunehmen. Allerdings können auch anderweitige Komponenten angeschraubt werden.

Ein Aufnahmeelement 5 beinhaltet in diesem Fall zwei Gewindeelemente, die in Flucht hintereinander angeordnet sind. Das dem Abschlussblech 2 nächstliegende Gewindeelement 51 hat den größten Gewindeinnendurchmesser, das fernliegenste Gewindeelement 52 den kleinsten. Auf diese Weise kann durch Ausnehmungen am Abschlussblech 2 eine Schraubverbindung hindurchtreten, bis das jeweilige Schraubgewinde in das passende Gewindeelement 51, 52 eingeschraubt werden kann. In diesem Fall sind die Gewindeelemente U-Profile mit eingeschnittenem Gewinde. In den Flanschen des U-Profils, die parallel zum Abschlussblech angeordnet sind, werden unterschiedliche Gewindedurchmesser eingeschnitten.

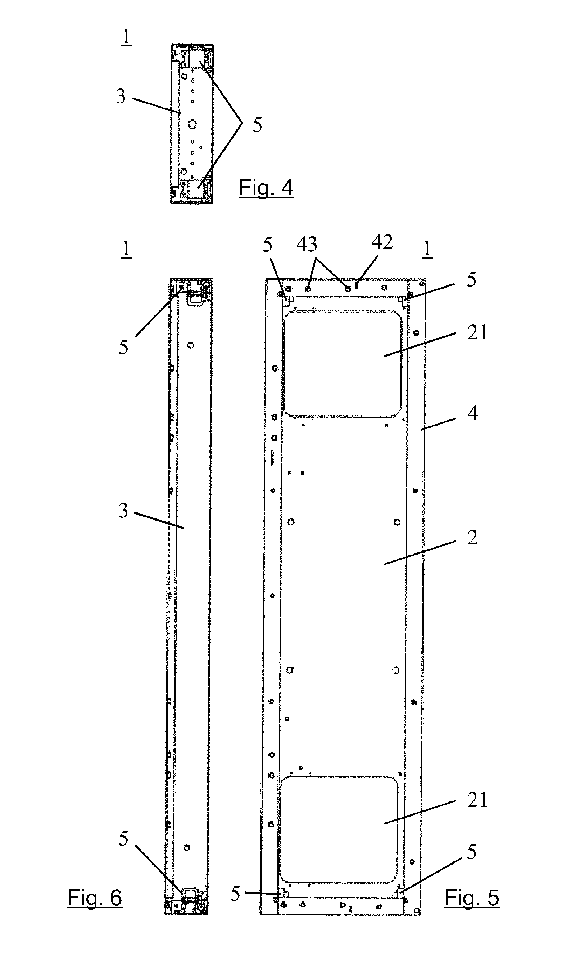

Fig. 4 zeigt schematisch eine Vorderansicht eines Dach-/Bodenelements 1 gemäß Fig. 2. Durch die kurze Seitenfläche 3 angedeutet sind die Aufnahmeelemente 5 positioniert. Fig. 5 zeigt schematisch eine Draufsicht auf ein Dach-/Bodenelements 1 gemäß Fig. 2. In der Draufsicht ist die Symmetrie des gesamten Bauteils gut zu erkennen, die eine wichtige Voraussetzung für einen variablen Einsatz ist. Fig. 6 zeigt schematisch eine Seitenansicht eines Dach-/Bodenelements 1 gemäß Fig. 2. Auch in dieser Figur sind die jeweiligen Positionen der Aufnahmeelemente 5 durch die lange Seitenfläche 3 hindurch angedeutet.

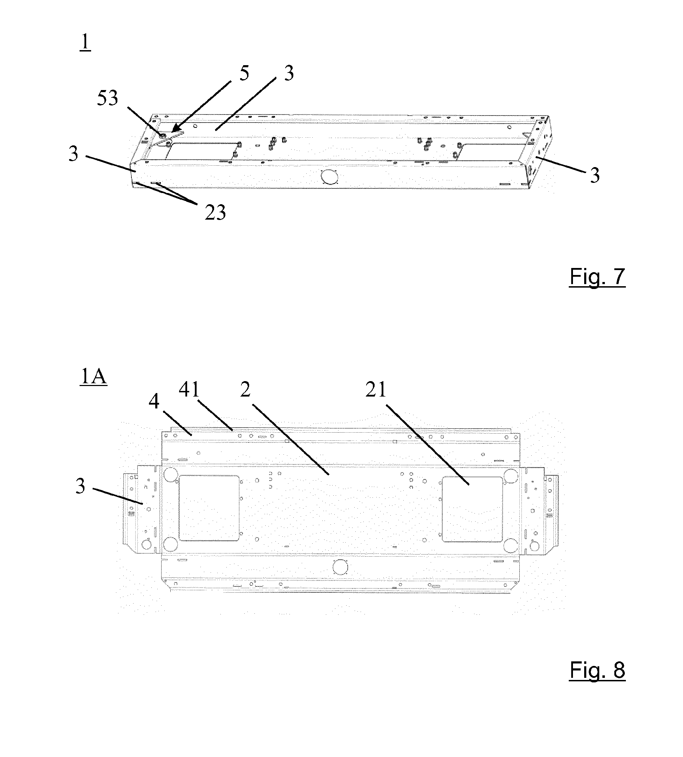

Fig. 7 zeigt schematisch eine Schrägansicht eines Dach-/Bodenelements 1 mit alternativem Aufnahmeelement 5. Das Aufnahmeelement 5 ist als Winkelelement an den Seitenflächen 3 mit einer Schweißverbindung befestigt. Mittig im Winkelelement ist ein Gewindeelement 53 als Haltevorrichtung angeordnet. In das Gewindeelement 53 kann bei der Verwendung als Bodenelement ein Gestellfuß eingeschraubt werden, in der Verwendung als Dachelement dient es beispielsweise zur Halterung einer Transportöse. Bei einem Winkelelement als Aufnahmeelement 5 handelt es sich in diesem Fall um ein dreieckiges Flachblech mit einem rechten Winkel, auch als Knotenblech bezeichnet, das in den Ecken eines Dach-/Bodenelements an die Seitenflächen 3 an- oder eingeschweißt ist.

Das Knotenblech ist mit in Fig. 7 nicht explizit dargestellten Anschlusslaschen zur stabilen Verbindung in Ausnehmungen 23 in den Seitenflächen 3 ausgeführt. Bei den Anschlusslaschen handelt es sich um Auskragungen entlang der Kanten der dreieckigen Bleche, die in Ausnehmungen 23 der Seitenflächen 3 eines Dach-/Bodenelements eingesteckt und verschweißt werden.

Fig. 8 zeigt schematisch eine Draufsicht auf ein flaches Blechmaterial 1A, zur Ausbildung eines Dach-/ Bodenelements 1. Es handelt sich um ein geometrisch vergleichsweise einfaches Biegeteil, aus dem ein Dach-/Bodenelement 1 vorgeformt wird. Das Blechmaterial 1A weist bereits alle Ausnehmungen und Flächen auf, die im fertig gestellten Zustand benötigt werden. So sind das Abschlussblech 2 mit Ausnehmungen 21, die Seitenflächen 3 und der Innenflansch 4 mit dem inneren Teil 41 ausgestanzt oder lasergeschnitten und in einem Stück ausgeführt. Das über die Biegekanten geformte Blechmaterial 1A wird entlang der gemeinsamen Fügekanten als Ganzes verschweißt und damit stabilisiert.

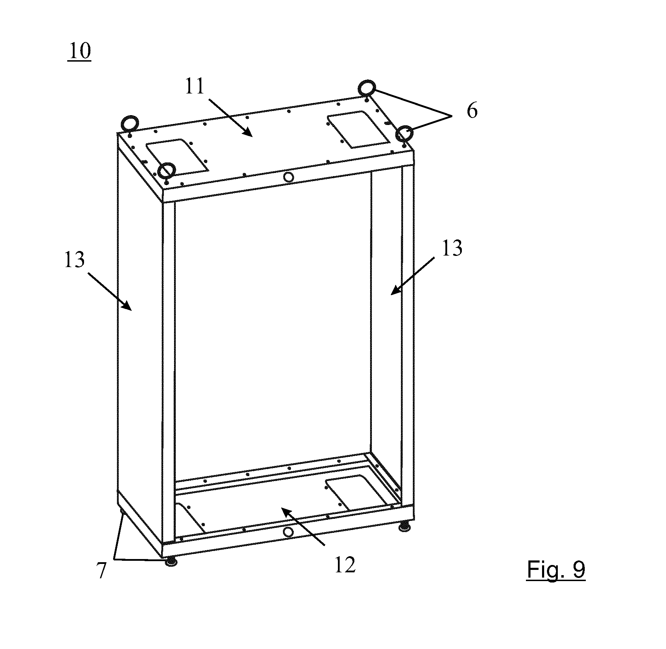

Fig. 9 zeigt schematisch einen Verteilerschrank 10 mit Dach-/Bodenelementen 1. Der Verteilerschrank 10 besteht, wie dargestellt, in seiner Gehäusegrundform aus einem Dachelement 11 und einem Bodenelement 12 sowie aus Seitenteilen 13. Auf der Oberseite sind am Dachelement 11 vier Transportösen 6 angebracht. Das Bodenelement 12 steht auf vier Stellfüßen 7. Folglich ergibt sich aus der flexiblen Einsetzbarkeit eines Dach-/Bodenelements dessen Funktion erst im verbauten Zustand.

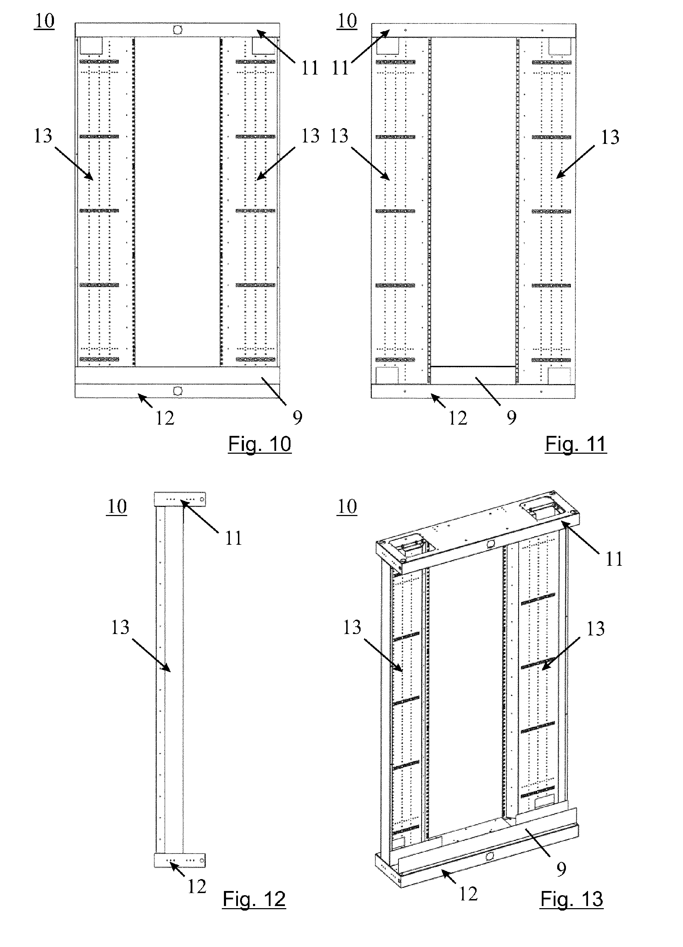

Fig. 10 zeigt schematisch eine Vorderansicht eines Verteilerschranks 10. Der Verteilerschrank 10 besteht aus einem Bodenelement 12 auf dem ein Kabelführungskanal 9 angeordnet ist. Die beiden Seitenteile 13 sind im Bodenelement 12 eingesteckt und mit diesem verschraubt. In den Seitenteilen 13 ist eine Vielzahl von regelmäßig angeordneten Löchern und Halteleisten vorhanden, die als Halteeinrichtung für weitere Systemkomponenten dienen. Das Dachelement 11 ist von oben in die Seitenteile 13 eingesteckt und mit diesen ebenfalls verschraubt. Die weitere Fig. 11 zeigt schematisch eine Rückansicht des Verteilerschranks 10. Auch dort sind an der Rückseite der Seitenteile 13 in vertikaler Richtung Halteleisten in gewissen Abständen vorhanden. Fig. 12 zeigt schematisch eine Seitenansicht und Fig. 13 eine Schrägansicht des Verteilerschranks 10. Am Bodenelement 12 ist der Kabelführungskanal 9, von der Vorderkante aus gesehen, so zurückversetzt angeordnet, dass in der Tiefe der Platzbedarf für eine Schranktür vorhanden ist. Die in der Figur nicht weiter dargestellten Kabelführungstonnen können als Zubehörteile in die Seitenteile 13 in die dargestellten und dafür vorgesehen Einzellöcher oder Lochmuster eingehängt und beispielsweise mit einer Schraube von der Rückseite her befestigt werden. Auch auf dem Kabelführungskanal 9 selbst können Kabelführungstonnen angeordnet sein.

### Bezugszeichenliste:

| | |
|---|---|
| 1 | Dach-/Bodenelement |
| 1A | Blechmaterial für Dach-/Bodenelement |
| 2 | Abschlussblech |
| 21 | erste Ausnehmungen |
| 22 | weitere Ausnehmungen |
| 23 | Ausnehmungen für Anschlusslaschen |
| 3 | Seitenflächen |
| 4 | Innenflansch |
| 41 | innerer Teil des Innenflansches |
| 42 | Positionierschlitze |
| 43 | Bohrungen |
| 5 | Aufnahmeelemente |
| 51 | nächstliegendes Gewindeelement |
| 52 | fernliegenstes Gewindeelement |
| 53 | Gewindeelement an Winkelelement |
| 6 | Transportösen |
| 7 | Stellfüße |
| 8 | Kanal |
| 9 | Kabelführungskanal |
| 10 | Verteilerschrank |
| 11 | Dachelement |
| 12 | Bodenelement |
| 13 | Seitenteil |

## Patentansprüche

1. Dach-/Bodenelement (1) für einen Verteilerschrank (10), welches ein Abschlussblech (2), Seitenflächen (3) und einen Innenflansch (4) aufweist,
**dadurch gekennzeichnet,**
**dass** dieses einstückig ausgebildet ist.

2. Dach-/Bodenelement (1) nach Anspruch 1,
**dadurch gekennzeichnet, dass** randseitig Aufnahmeelemente (5) zum wahlweisen Befestigen von Transportösen (6) oder von Stellfüßen (7) angeordnet sind.

3. Dach-/Bodenelement (1) nach Anspruch 2,
**dadurch gekennzeichnet, dass** das jeweilige Aufnahmeelement (5) mehrere in Flucht hintereinander angeordnete Gewindeelemente mit unterschiedlichem Gewindeinnendurchmesser beinhaltet, wobei das dem Abschlussblech (2) nächstliegende Gewindeelement (51) den größten Gewindeinnendurchmesser, das fernliegenste Gewindeelement (52) den kleinsten Gewindeinnendurchmesser aufweist.

4. Dach-/Bodenelement (1) nach Anspruch 2,
**dadurch gekennzeichnet, dass** das jeweilige Aufnahmeelement (5) als Winkelelement an den Seitenflächen (3) fixiert ist und mit zumindest einem Gewindeelement (53) als Haltevorrichtung ausgestaltet ist.

5. Dach-/Bodenelement (1) nach Anspruch 4,
**dadurch gekennzeichnet, dass** das Winkelelement mit Anschlusslaschen zur Verbindung in Ausnehmungen (23) in den Seitenflächen (3) ausgeführt ist.

6. Dach-/Bodenelement (1) nach einem der Ansprüche 1 bis 5,
**dadurch gekennzeichnet, dass** der innere Teil (41) des Innenflansches (4) zum Abschlussblech (2) hin umgebogen ist.

7. Dach-/Bodenelement (1) nach einem der Ansprüche 1 bis 6,
**dadurch gekennzeichnet, dass** im Inneren zusätzlich ein sich über den mittleren Bereich erstreckender Kanal (8) angeordnet ist.

8. Dach-/Bodenelement (1) nach einem der Ansprüche 1 bis 7,
**dadurch gekennzeichnet, dass** Positionierschlitze (42) oder Positioniernasen am Innenflansch (4) angeordnet sind.

9. Dach-/Bodenelement (1) nach einem der Ansprüche 1 bis 8,
**dadurch gekennzeichnet, dass** im Abschlussblech (2) erste Ausnehmungen (21) zur Durchführung von Kabeln eingebracht sind.

10. Dach-/Bodenelement (1) nach einem der Ansprüche 1 bis 9,
**dadurch gekennzeichnet, dass** im Abschlussblech (2) weitere Ausnehmungen (22) zur Anordnung weiterer Systemelemente eingebracht sind.

11. Dach-/Bodenelement (1) nach einem der Ansprüche 1 bis 10,
**dadurch gekennzeichnet, dass** Stahlblech oder verzinktes Stahlblech verwendet ist.

12. Dach-/Bodenelement (1) nach einem der Ansprüche 1 bis 11,
**dadurch gekennzeichnet, dass** die Oberfläche pulverbeschichtet ist.

13. Dach-/Bodenelement (1) nach einem der Ansprüche 1 bis 12,
**dadurch gekennzeichnet, dass** dieses aus einem gebogenen und gefügten Blechmaterial (1 A) gebildet ist.

14. Verteilerschrank (10),
**gekennzeichnet, durch** ein Dachelement (11) und ein Bodenelement (12) nach einem der Ansprüche 1 bis 13 und Seitenteilen (13) sowie wahlweise weiteren Systemelementen.
